Europäisches Patentamt

European Patent Office

Office européen des brevets

(11) Veröffentlichungsnummer: **0 270 855**
**A1**

(12) **EUROPÄISCHE PATENTANMELDUNG**

(21) Anmeldenummer: **87116522.1**

(22) Anmeldetag: **09.11.87**

(51) Int. Cl.⁴: **G01R 27/26**

(30) Priorität: **11.11.86 DE 3638389**

(43) Veröffentlichungstag der Anmeldung:
**15.06.88 Patentblatt 88/24**

(84) Benannte Vertragsstaaten:
**AT DE FR GB IT NL SE**

(71) Anmelder: **Siemens Aktiengesellschaft Berlin und München**
**Wittelsbacherplatz 2**
**D-8000 München 2(DE)**

(72) Erfinder: **Schatter, Eckart, Dipl.-Ing.**
**Herzog-Stephan-Weg 5**
**D-8011 Zorneding(DE)**

(54) Verfahren zur Bestimmung von Güten und/oder Frequenzen elektrischer Schwingkreise.

(57) Der Schwingkreis wird durch mindestens einen Schaltstoß sehr hoher Flankensteilheit angeregt und die dann folgende abklingende Schwingung ausgewertet

# FIG 1

EP 0 270 855 A1

## Verfahren zur Bestimmung von Güten und/oder Frequenzen elektrischer Schwingkreise

Die vorliegende Erfindung betrifft ein Verfahren nach dem Oberbegriff des Patentanspruches 1.

In einer Vielzahl von Anwendungsfällen werden Güten und/oder Frequenzen elektrischer Schwingkreise gemessen bzw. bestimmt. Für den Bereich des Messens werden beispielsweise Schwingkreisgüten üblicherweise dadurch bestimmt, daß die Güte der Schwingkreisinduktivität, die in aller Regel die Güte des Schwingkreises wesentlich bestimmt, in einer Brücke dadurch bestimmt wird, daß Real-und Imaginärteil in der Brücke bei einer festen Frequenz gemessen werden. Dies ist insofern noch nachteilig, weil in aller Regel die Meßfrequenz in der Brücke nicht gleich der Resonanzfrequenz des Schwingkreises ist, in dem die Induktivität zur Anwendung kommt.

Ein Fall, in dem sich ändernde Schwingkreisgüten vorkommen und ausgewertet werden, ist ein induktiver Annäherungsschalter. Ein derartiger induktiver Annäherungsschalter ist beispielsweise aus der DE-PS 23 56 490 bekannt. Er wird im Grundsatz durch einen Oszillator und einen diesem nachgeschalteten Schaltverstärker gebildet, der die Amplitude der Oszillatorschwingung auswertet. Das Arbeitsprinzip eines solchen induktiven Annäherungsschalters beruht darauf, daß der frequenzbestimmende Schwingkreis des Oszillators dadurch bedämpft oder entdämpft wird, daß seiner Induktivität ein ferromagnetisches Teil mehr oder weniger angenähert wird. Bei Bedämpfung durch ein angenähertes ferromagnetisches Teil ist die Amplitude der Oszillatorschwingung klein oder nicht mehr vorhanden, während sie bei Entdämpfung durch Entfernung des ferromagnetischen Teils einen vorgegebenen großen Wert besitzt.

Derartig ausgebildete Annäherungsschalter sind einerseits deshalb nachteilig, weil Oszillatoren endliche und auch praktisch ins Gewicht fallende Anschwingzeiten besitzen. Für den Fall des erstmaligen Einschaltens eines induktiven Annäherungsschalters ergeben sich daher endliche nicht zu vernachlässigende Zeiten bis zur Betriebsbereitschaft. Für Fälle, in denen die Oszillatorschwingungen bei Bedämpfung des Schwingkreises über die Schwingkreisinduktivität vollständig abreißen, ergeben sich diese Probleme auch im stationären Betrieb, weil der Oszillator nach Entdämpfung des Schwingkreises ebenfalls wieder die endliche Anschwingzeit bis zum Erreichen seines stationären Schwingungszustandes benötigt, woraus im stationären Betrieb des induktiven Annäherungsschalters Totzeiten bei der Umschaltung vom bedämpften in den entdämpften Zustand vorhanden sind.

Der vorliegenden Erfindung liegt die Aufgabe zugrunde, eine Möglichkeit zur Bestimmung von Schwingkreisgüten und/oder -frequenzen für die vorstehend erläuterten Anwendungsfälle ohne die genannten Nachteile anzugeben.

Diese Aufgabe wird bei einem Verfahren der eingangs genannten Art erfindungsgemäß durch die Merkmale des kennzeichnenden Teils des Patentanspruches 1 gelöst.

Ausgestaltungen des Erfindungsgedankens sind Gegenstand von Unteransprüchen.

Die Erfindung wird im folgenden anhand von Ausführungsbeispielen gemäß den Figuren der Zeichnung näher erläutert. Es zeigt:

FIG 1 ein schematisches Schaltbild einer Prinzipschaltungsanordnung zur Durchführung des erfindungsgemäßen Verfahrens;

FIG 2 A und B jeweils ein Diagramm zur Erläuterung von Signalverläufen an verschiedenen Knotenpunkten in der Prinzipschaltung nach FIG 1;

FIG 3 ein Schaltbild einer Schaltungsanordnung zur Durchführung des erfindungsgemäßen Verfahrens mit einer einen Serienresonanzkreis speisenden Spannungsquelle; und

FIG 4 ein Schaltbild einer Schaltungsanordnung zur Durchführung des erfindungsgemäßen Verfahrens mit einer einen Parallelresonanzkreis speisenden Stromquelle.

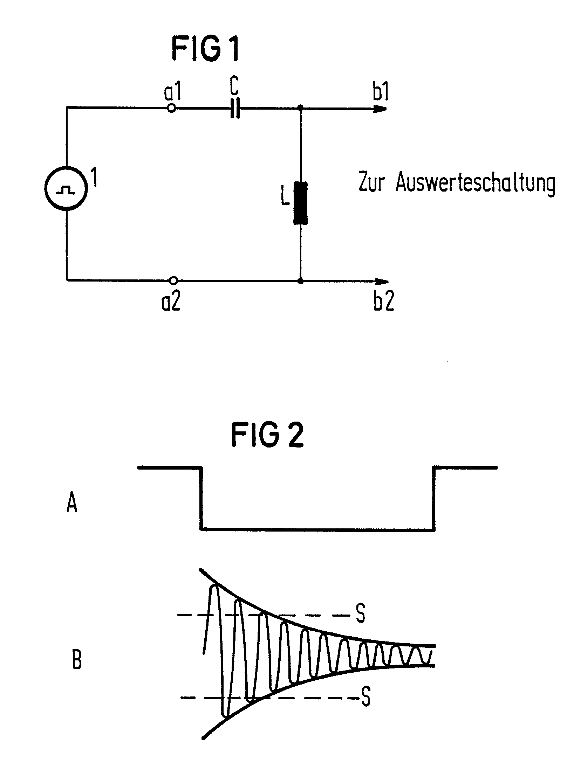

Das erfindungsgemäße Verfahren wird im folgenden zunächst anhand des Prinzipschaltbildes nach FIG 1 sowie anhand der Signaldiagramme nach FIG 2 erläutert.

Gemäß FIG 1 speist eine einen Schaltstoß liefernde Quelle 1 einen Schwingkreis, der hier durch einen Serienresonanzkreis mit einer Kapazität C und einer Induktivität L gebildet wird. An Knotenpunkten a1 und a2 liefert die Quelle 1 nach FIG 1 mindestens einen Schaltstoß gemäß dem Signaldiagramm nach FIG 2A. Durch diesen Schaltstoß wird der durch die Kapazität C und die Induktivität L gebildete Serienresonanzkreis zu einer abklingenden (gedämpften) Schwingung gemäß FIG 2B angeregt, welche in der Prinzipschaltung nach FIG 1 an Knotenpunkten b1 und b2 auftritt. Die an diesen Knotenpunkten entstehende abklingende Schwingung kann durch eine in den Zeichnungen nicht eigens dargestellte an sich bekannte Auswerteschaltung ausgewertet werden.

Erfindungsgemäß sollen die Flankenanstiegs- und abfallzeit des den Schwingkreis anstoßenden Schaltstoßes gemäß FIG 2A klein gegen die der Resonanzfrequenz des Schwingkreises entsprechende Periodendauer sein. Dies ist deshalb zweckmäßig, damit die dem Schwingkreis zugeführte Stoßenergie nur von der Amplitude des Schaltstoßes, nicht aber von der Steilheit der Schaltflanke abhängt.

Für den Fall eines Schwingkreises in Form eines Serienresonanzkreises, wie er in FIG 1 dargestellt ist, ist die den Schaltstoß liefernde Quelle eine einen Spannungssprung liefernde Spannungsquelle, deren Innenwiderstand klein gegen den Serienresonanz-Verlustwiderstand des Schwingkreises ist. Die Bemessung des Innenwiderstandes dieser Spannungsquelle ist deshalb so getroffen, daß der Schwingkreis während der abklingenden Schwingung nach FIG 2B nur durch seinen eigenen Verlustwiderstand, nicht aber auch noch durch den Innenwiderstand der Spannungsquelle bedämpft wird.

Die abklingende Schwingung wird zweckmäßigerweise an der Induktivität des Serienresonanzkreises abgegriffen, weil an ihr eine Resonanzüberhöhung auftritt und damit eine Spannung genügend hoher Amplitude zur Verfügung steht, die leicht auswertbar ist.

Für den Fall eines Schwingkreises in Form eines Parallelresonanzkreises wird der Schaltstoß in weiterer Ausgestaltung der Erfindung durch eine einen Stromsprung liefernde Stromquelle erzeugt, deren Innenwiderstand groß gegen den Parallelresonanz-Verlustwiderstand des Schwingkreises ist. Die Bemessung des Innenwiderstandes der Stromquelle ist wiederum so gewählt, daß der Schwingkreis, hier der Parallelresonanzkreis, während der abklingenden Schwingung nach FIG 2B nur durch seinen eigenen Verlustwiderstand, nicht aber auch noch durch den Innenwiderstand der Stromquelle bedämpft wird.

Im Prinzip ist das erfindungsgemäße Verfahren mit lediglich einem Schaltstoß und einer daraus resultierenden abklingenden Schwingung ausführbar. Dies gilt im Grundsatz beispielsweise für die Messung der Güte eines Schwingkreises, in dem eine einzige abklingende Schwingung nach FIG 2B bei einem einzigen Schaltstoß nach FIG 2A in im folgenden noch zu erläuternder Weise ausgewertet wird.

Besonders günstige Verhältnisse werden jedoch erreicht, wenn einem Schwingkreis Schaltstöße periodisch zugeführt werden. Die Schaltstöße sollen dabei in so großem zeitlichen Abstand aufeinander folgen, daß die jeweils aus ihnen resultierende abklingende Schwingung ausreichend weit abgeklungen ist. Damit ist gewährleistet, daß die Energie im Schwingkreis nur durch den sie erzeugenden letzten Schaltstoß, aber nicht mehr durch die Vorgeschichte vorangegangener Schaltstöße bestimmt wird. Um eine genügend hohe Meßgeschwindigkeit realisieren zu können, ist es insbesondere vorteilhaft, den Schwingkreis nach der Auswertung einer abklingenden Schwingung zu bedämpfen. Damit wird nämlich sichergestellt, daß etwa nach der Auswertung im Schwingkreis noch vorhandene Energie schnell und sicher abgebaut wird.

Diese Bedämpfung des Schwingkreises kann beispielsweise dadurch erfolgen, daß der Innenwiderstand der Schaltstoßquelle nach der Auswertung der abklingenden Schwingung auf einen definierten Wert umgeschaltet wird.

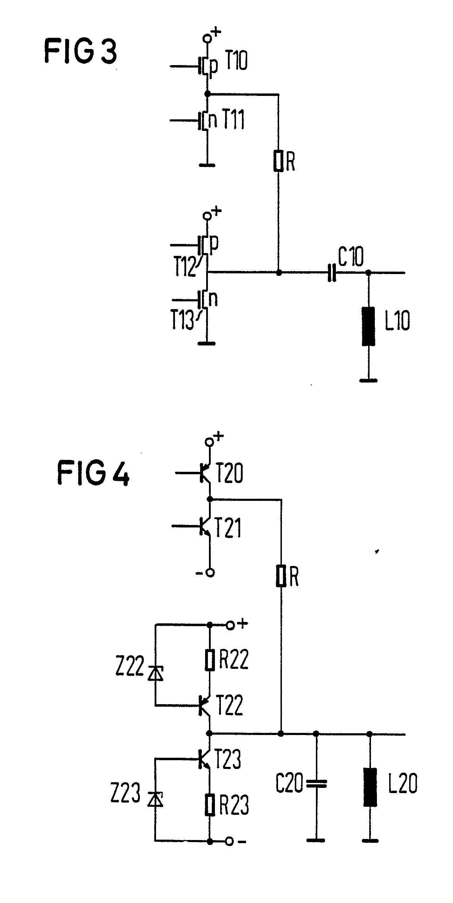

Ausführungsbeispiele für eine Umschaltung des Innenwiderstandes sowohl für eine einen Spannungssprung liefernde Spannungsquelle als auch eine einen Stromsprung liefernde Stromquelle sind in FIG 3 bzw. in FIG 4 dargestellt.

FIG 3 zeigt eine Ausführungsform einer Spannungsquelle mit umschaltbarem Innenwiderstand, die in vorteilhafter Weise monolithisch, vorzugsweise in CMOS-Technologie integriert ist.

Die dargestellte Spannungsquelle enthält jeweils zwei in Reihe liegende komplementäre Transistoren T10, T11 bzw. T12, T13. Um anzudeuten, daß es sich bei dem jeweils oberen Transistor um einen p-Kanal-Transistor und bei dem jeweils unteren Transistor um einen n-Kanal-Transistor handelt, sind die entsprechenden Symbole jeweils für den Transistor angedeutet. Die Ausgänge der beiden Komplementärstufen sind durch einen Widerstand R miteinander verbunden, der die Änderung des Innenwiderstandes der Spannungsquelle durch Umschaltung bewirkt. Die Spannungsquelle speist einen Schwingkreis in Form eines Serienresonanzkreises aus ein Kapazität C10 und einer Induktivität L10. Durch einen Pfeil ist wiederum die Weiterführung auf eine Auswerteschaltung angedeutet.

Um die Spannungsquelle während der Erzeugung eines Schaltstoßes mit kleinem Innenwiderstand und nach der Auswertung der durch den Schaltstoß hervorgerufenen abklingenden Schwingung mit größerem Innenwiderstand betreiben zu können, werden die Transistoren T10 bis T13 folgendermaßen angesteuert: Während eines Schaltstoßes werden zunächst die Transistoren T10 und T12 leitend geschaltet, so daß der Transistor T12 den Innenwiderstand kleinen Wertes festlegt, weil von einer schematisch mit + bezeichneten Betriebsspannungsquelle ein leitender Pfad über den Transistor T12 auf den Serienresonanzkreis führt. Ist nun die durch diesen Schaltstoß hervorgerufene abklingende Schwingung ausgewertet, so wird nur noch der Transistor T10 leitend gesteuert, so daß nunmehr von der wiederum schematisch mit + bezeichneten Betriebsspannungsquelle ein Zweig über diesen Transistor und den Widerstand R auf den Serienresonanzkreis führt, so daß der nunmehr größere Innenwiderstand der Spannungsquelle durch den Widerstand R bestimmt ist.

Für die Umkehrung der Polarität eines Schaltstoßes können entsprechend während der Erzeugung eines solchen Schaltstoßes und der nachfolgenden Auswertung der durch diesen hervorgerufenen abklingenden Schwingung die Transistoren T11 und T13 leitend gesteuert werden, während zur Erhöhung des Innenwiderstandes nach der Auswertung der abklingenden Schwingung allein der Transistor T11 leitend gesteuert wird.

Eine Logik zur entsprechenden Ansteuerung der Transistoren im vorgenannten Sinne kann in an sich bekannter Weise ausgeführt werden, wobei sich ihre schaltungstechnische Aus gestaltung unmittelbar aus der vorstehend erläuterten Ansteuerungsfolge der Transistoren ergibt.

FIG 4 zeigt die entsprechenden Verhältnisse für die Umschaltung des Innenwiderstandes einer Stromquelle zur Speisung eines aus einer Kapazität C20 und einer Induktivität L20 gebildeten Parallelresonanzkreises. Diese vorzugsweise in bipolarer integrierter Technik ausgebildete Schaltungsanordnung enthält analog zur Ausführungsform nach FIG 3 zwei in Reihe liegende komplementäre Transistorpaare T20,T21 bzw. T22,T23. Im oberen komplementären Transistorpaar T20,T21 liegen die Emitter an jeweils einer schematisch mit + bzw. - bezeichneten Betriebsspannungsquelle, während im unteren komplementären Transistorpaar T22,T23 die Emitter über jeweils einen Emitterwiderstand R22 bzw. R23 an der positiven bzw. negativen Betriebsspannungsquelle liegen. Weiterhin liegt die Basis des Transistors T22 über eine Zener-Diode Z22 an der positiven Betriebsspannungsquelle und die Basis des Transistors T23 über eine Zener-Diode Z23 an der negativen Betriebsspannungsquelle. Der Widerstand R ist entsprechend der Ausführungsform nach FIG 3 wiederum das Element, über das der Innenwiderstand der Stromquelle umschaltbar ist. Der von der Stromquelle gespeiste Parallelresonanzwiderstand wird durch eine Kapazität C20 und eine Induktivität L20 gebildet.

Bei dieser Ausführungsform der Stromquelle wird ein Schaltstoß jeweils einer Polarität durch Ansteuerung des Transistors T22 bzw. des Transistors T23 erzeugt, während der Widerstand R eingeschaltet und damit der Innenwiderstand umgeschaltet wird, indem für die jeweilige Polarität der Transistor T20 bzw. der Transistor T21 durchgeschaltet wird. Eine entsprechend ausgebildete an sich bekannte Logik zur Ansteuerung der Transistoren ist ebenfalls wiederum durch die Ansteuerungsfolge der Transistoren direkt gegeben.

Wie bereits anhand der Ausführungsformen für Schaltstoßquellen nach den FIG 3 und 4 erwähnt, können die Schaltstöße mit wechselnder Polarität in den Schwingkreis eingespeist werden, wobei die sich daraus ergebenden abklingenden Schwingungen paarweise ausgewertet werden.

Die Auswertung der abklingenden Schwingungen kann beispielsweise dadurch erfolgen, daß die Anzahl der Perioden in der abklingenden Schwingung, die eine vorgegebene Amplitude übersteigen, bestimmt und ausgewertet wird. Eine derartige vorgegebene Amplitude ist in FIG 2B beispielsweise durch eine gestrichelt dargestellte Schaltschwelle S angedeutet. Die Bestimmung der Anzahl der Perioden, welche die vorgegebene Amplitude übersteigen, kann schaltungstechnisch beispielsweise dadurch realisiert werden, daß die abklingende Schwingung auf einen Schmitt-Trigger mit der angegebenen Schaltschwelle S gegeben wird, und die Anzahl der Umschaltungen, die der Schmitt-Trigger durch Amplituden oberhalb der Schaltschwelle S erfährt, gezählt werden. Eine Auswertung kann dann so erfolgen, daß durch den Zählwert beispielsweise ein Schaltglied angesteuert wird.

Weiterhin kann auch die Zeit nach dem Schaltstoß, in der die abklingenden Schwingungen eine vorgegebene Amplitude überschreiten, bestimmt und ausgewertet werden. Die vorgegebene Amplitude kann dabei wiederum beispielsweise durch die Schaltschwelle S nach FIG 2B gegeben sein. Diese Art der Auswertung kann in an sich bekannter Weise schaltungstechnisch beispielsweise dadurch realisiert werden, daß ein von einer Zeitreferenz gesteuerter Zähler mit der abklingenden Schwingung beaufschlagt wird.

Es ist selbstverständlich auch möglich, die Bestimmung und Auswertung über die Anzahl der Perioden in der abklingenden Schwingung und über die Zeit nach dem Schaltstoß zu kombinieren, beispielsweise um die Resonanzfrequenz eines Schwingkreises zu bestimmen. Weiterhin wird es damit auch möglich, neben der Erfassung eines Ereignisses, beispielsweise nach Art der Bedämpfung des Resonanzkreises des Oszillators eines induktiven Annäherungsschalters, den Wert einer physikalischen Größe, beispielsweise den Absolutwert des Abstandes eines den Schwingkreis eines Ozillators in einem induktiven Annäherungsschalter bedämpfenden ferromagnetischen Teils zu bestimmen. Ein weiteres Beispiel für die Bestimmung des Absolutwertes einer physikalischen Größe wäre die Bestimmung des Druckes über eine mit einer Membran versehenen Druckdose, wobei die Membran im Bereich der Induktivität eines Schwingkreises angeordnet wird und aus dem jeweiligen Abstand der Membran von der Induktivität bei unterschiedlichen Druckwerten in der Druckdose der jeweilige Druckwert unmittelbar bestimmt werden kann.

**Ansprüche**

1. Verfahren zur Bestimmung von Güten und/oder Frequenzen elektrischer Schwingkreise,**dadurch gekennzeichnet**, daß der Schwingkreis durch einen Schaltstoß angeregt wird, dessen Flankenanstiegs-bzw. -abfall-zeit klein gegen die der Resonanzfrequenz des Schwingkreises entsprechende Periodendauer ist, und daß die auf den Schaltstoß folgende abklingende Schwingung ausgewertet wird.

2. Verfahren nach Anspruch 1, **dadurch gekennzeichnet**, daß für den Fall eines Schwingkreises in Form eines Serienresonanzkreises der Schaltstoß ein Spannungssprung aus einer Spannungsquelle ist, deren Innenwiderstand klein gegen den Serienresonanz-Verlustwiderstand des Schwingkreises ist.

3. Verfahren nach Anspruch 2, **dadurch gekennzeichnet**, daß die abklingende Schwingung an der Induktivität des Serienresonanzkreises abgegriffen wird.

4. Verfahren nach Anspruch 1, **dadurch gekennzeichnet**, daß für den Fall eines Schwingkreises in Form eines Parallelresonanzkreises der Schaltstoß ein Stromsprung aus einer Stromquelle ist, deren Innenwiderstand groß gegen den Parallelresonanz-Verlustwiderstand des Schwingkreises ist.

5. Verfahren nach einem der Ansprüche 1 bis 4, **dadurch gekennzeichnet** , daß dem Schwingkreis Schaltstöße periodisch zugeführt werden.

6. Verfahren nach Anspruch 5, **dadurch gekennzeichnet**, daß die Schaltstöße in so großem zeitlichen Abstand folgen, daß die Schwingung ausreichend weit abgeklungen ist.

7. Verfahren nach Anspruch 5, **dadurch gekennzeichnet**, daß der Schwingkreis nach Auswertung der abklingenden Schwingung bedämpft wird.

8. Verfahren nach Anspruch 7, **dadurch gekennzeichnet**, daß zur Bedämpfung des Schwingkreises der Innenwiderstand der Schaltstoßquelle auf einen definierten Wert umgeschaltet wird.

9. Verfahren nach Anspruch 5, **dadurch gekennzeichnet**, daß Schaltstöße wechselnder Polarität in den Schwingkreis eingespeist werden und daß die sich daraus ergebenden abklingenden Schwingungen paarweise ausgewertet werden.

10. Verfahren nach einem der Ansprüche 1 bis 9, **dadurch gekennzeichnet**, daß die Anzahl der Perioden in der abklingenden Schwingung, die eine vorgegebene Amplitude übersteigen, bestimmt und ausgewertet wird.

11. Verfahren nach einem der Ansprüche 1 bis 10, **dadurch gekennzeichnet**, daß die Zeit nach dem Schaltstoß, in der die abklingenden Schwingungen eine vorgegebene Amplitude überschreiten, bestimmt und ausgewertet wird.

# FIG 1

a1    C    b1

1

L    Zur Auswerteschaltung

a2    b2

# FIG 2

A

B

S

S

# FIG 3

T10 p

T11 n

R

T12 p

T13 n

C10

L10

# FIG 4

T20

T21

R

Z22

R22

T22

Z23

T23

R23

C20

L20

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | ELECTRONICS, Band 45, Nr. 21, 9. Oktober 1972, Seiten 119-120, New York, US; C. VENDITTI: "Single time measurement determines capacitor R and L" <br> * Insgesamt; Figuren 1-3 * | 1 | G 01 R 27/26 |
| A | Idem <br> --- | 2,5,6 | |
| X | AT-C- 330 891 (PENZENSKY INSTITUT) <br> * Seite 2, Zeile 1 - Seite 3, Zeile 25; Figuren 1-6 * <br> --- | | |
| A | NACHRICHTENTECHNIK ELEKTRONIK, Band 29, Nr. 1, Januar 1979, Seiten 22-24, Berlin, DE; B. RICHTER et al.: "Eine Methode zur Parametermessung an passiven linearen Bauelementen innerhalb analoger Schaltungen" <br> * Seite 22, Spalte 1, Zeilen 1-40; Figuren 1,2 * <br> --- | 1 | |
| A | F.E. TERMAN et al.: "Electronic measurements", Ausgabe 2, 1952, Seiten 332-333, McGraw-Hill Publishing Co., Ltd, London, GB <br> * Seite 332, Zeile 1 - Seite 333, Zeile 10; Figuren 8-18 * <br> --- | 1,5-6 | RECHERCHIERTE SACHGEBIETE (Int. Cl.4) <br><br> G 01 R 27/00 |
| A | HEWLETT-PACKARD JOURNAL, Band 28, Nr. 1, September 1976, Seiten 9-15, Palo Alto, US; S. HASHIMOTO et al.: "An automatic wide-range digital LCR meter" <br> * Seite 10, Spalte 1, Zeile 13 - Spalte 2, Zeile 11; Figur 2 * <br> ---       -/- | 2,4 | |

Der vorliegende Recherchenbericht wurde für alle Patentansprüche erstellt

| Recherchenort | Abschlußdatum der Recherche | Prüfer |
|---|---|---|
| DEN HAAG | 26-02-1988 | TRELEVEN C. |

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE-A-2 811 127  (LOEWE) <br> * Seite 5, Zeile 1 - Seite 6, Zeile 29; Figur 1 * <br> --- | 3,7-8, 10,11 | |
| A | INTERNATIONAL JOURNAL OF ELECTRONICS, Band 55, Nr. 4, Oktober 1983, Seiten 625-630, Basingstoke, Hampshire, GB; M. EMURA et al.: "An automatic digital Q-meter for low values of Q" <br> * Insgesamt; Figuren 1-4,7,8 * <br> --- | 10,11 | |
| A | MEASUREMENT TECHNIQUES, Band 29, Nr. 5, Mai 1986, Seiten 464-466, Plenum Publishing Corp., New York, US; S.N. ARTEMENKO et al.: "Digital Q-meter for superconducting microwave systems" <br> * Seite 464, Abschnitt 2; Seite 464, letzter Abschnitt - Seite 465, Zeile 2; Figuren 1,2 * <br> ----- | 10,11 | |

RECHERCHIERTE SACHGEBIETE (Int. Cl.4)

Der vorliegende Recherchenbericht wurde für alle Patentansprüche erstellt

| Recherchenort | Abschlußdatum der Recherche | Prüfer |
|---|---|---|
| DEN HAAG | 26-02-1988 | TRELEVEN C. |